# EUROPÄISCHE PATENTSCHRIFT

(11) **EP 0 332 983 B1**
(45) Veröffentlichungstag und Bekanntmachung des Hinweises auf die Patenterteilung: **15.06.1994**
(21) Anmeldenummer: 89103948.9
(22) Anmeldetag: 07.03.1989
(51) Int. Cl.: G03F 7/027, G03F 7/095, G03F 7/11

(54) **Photopolymerisierbare, zur Herstellung von Druckformen geeignete Druckplatte**
Photopolymerisable printing plate for the manufacture of printing formes
Plaque d'impression photopolymérisable pour la fabrication de formes d'impression

(30) Priorität: 17.03.1988 DE 3808951
(43) Veröffentlichungstag der Anmeldung: 20.09.1989
(73) Patentinhaber: BASF Aktiengesellschaft, 67063 Ludwigshafen (DE)
(72) Erfinder: Beck, Erich, Dr., D-6721 Harthausen (DE); Bronstert, Bernd, Dr., D-6701 Otterstadt (DE); Huemmer, Wolfgang, Dr., D-6703 Limburgerhof (DE); Littmann, Dieter, Dr., D-6717 Hessheim (DE)

(56) Entgegenhaltungen:
- EP-A- 0 128 014
- DE-A- 1 447 029
- CHEMICAL ABSTRACTS, Band 90, Nr. 6, 5. Februar 1979, Seite 29, Zusammenfassung Nr. 39669h, Columbus, Ohio, US; & JP-A-78 106 786
- CHEMICAL ABSTRACTS, Band 96, Nr. 26, 28. Juni 1982, Seite 632, Zusammenfassung Nr. 226603t, Columbus, Ohio, US; & JP-A-81 154 731
- PATENT ABSTRACTS OF JAPAN, Band 8, Nr. 27 (P-252)[1464], 4. Februar 1984; & JP-A-58 181 039

## Beschreibung

Die vorliegende Erfindung betrifft photopolymerisierbare, zur Herstellung von Druckformen, insbesondere von Flexodruckformen geeignete Druckplatten, die auf einem dimensionsstabilen Träger mindestens eine Zwischenschicht und darauf eine reliefbildende photopolymerisierbare Schicht tragen, die im wesentlichen aus einem Gemisch aus polymerem Bindemittel, mindestens einer ethylenisch ungesättigten polymerisierbaren Verbindung, Photoinitiator und thermischem Polymerisationsinhibitor besteht und bestimmte wasserlösliche Copolymere sowie bestimmte ethylenisch ungesättigte polymerisierbare Verbindungen enthält.

Photoempfindliche Polymerzusammensetzungen, die teilverseiftes Polyvinylacetat und ein polyfunktionelles Acrylat oder Methacrylat in Kombination mit die Verträglichkeit verbessernden mehrwertigen Alkoholen enthalten und zur Herstellung von Druckplatten verwendet werden können, sind beispielsweise aus der EP-A-00 81 964 bekannt.

In der EP-A-224 164 werden lichtempfindliche Aufzeichnungsmaterialien beschrieben, die als polymeres Bindemittel verseifte bzw. teilverseifte Pfropfcopolymerisate von Vinylestern auf Polyalkylenoxiden enthalten. Die Verträglichkeit der hierin aufgeführten Monomeren mit dem Bindemittel genügt jedoch in vielen Fällen nicht, um gesteigerte Anforderungen hinsichtlich Bildwiedergabequalität sowie Elastizität daraus hergestellter Druckformen zu erfüllen.

In der EP-A-00 36 301 wird ein lichtempfindliches Polyamidharzgemisch aus alkohollöslichem Polyamid, einer nicht polymeren Verbindung, die in ein und demselben Molekül sowohl Vinyl- als auch Epoxygruppen aufweist und mit dem polymeren Bindemittel unter Bildung copolymerisationsfähiger Polymerer reagieren kann, sowie einem polyfunktionellen Vinylmonomeren, das 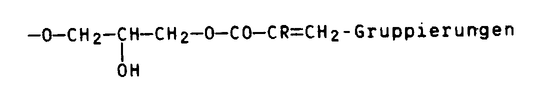
aufweist, beschrieben.

Demnach war die Verwendung von Phenylglycidyletheracrylat als weichmachende Komponente, mit polyfunktionellen Acrylaten kombiniert, in photopolymerisierbaren Druckplatten, die alkohollösliches modifiziertes Polyamid als polymeres Bindemittel enthalten, bereits bekannt gewesen.

Derartige Zusammensetzungen sind jedoch wegen des notwendigen Anteils polyfunktioneller Acrylate und der sich daraus ergebenden hohen Vernetzungsdichte nicht zur Herstellung weichelastischer flexotypischer Druckformen geeignet. Darüber hinaus ist die Verwendung von Alkohol als Entwicklermedium für die Herstellung der Druckform für viele Anwendungsbereiche unerwünscht.

Aufgabe der vorliegenden Erfindung ist es, photopolymerisierbare, zur Herstellung weichelastischer Druckformen geeignete Druckplatten aufzuzeigen, die die oben angeführten Nachteile nicht aufweisen und sich durch ausgezeichnete Verträglichkeit von monomerem und polymerem Bindemittel, Wasserentwickelbarkeit sowie hohe Elastizität bei geringer Härte ohne Verwendung extrahierbarer Weichmacher auszeichnen.

Diese Aufgabe läßt sich überraschenderweise dadurch lösen, daß in den photopolymerisierbaren reliefbildenden Schichten Phenylglycidylether(meth)acrylate oder ähnliche Verbindungen, d.h. spezielle monofunktionelle (Meth)acrylate mit modifziertem Polyvinylalkohol als polymerem Bindemittel kombiniert werden, ohne daß polyfunktionelle (Meth)acrylate oder mit ethylenisch ungesättigten Gruppen funktionalisierte Bindemittel mitverwendet werden müssen.

Gegenstand der vorliegenden Erfindung ist eine photopolymerisierbare, zur Herstellung weichelastischer Druckformen geeignete Druckplatte, die auf einem dimensionsstabilen Träger mindestens eine Zwischenschicht und darauf eine photopolymerisierbare Schicht trägt, die im wesentlichen aus einem Gemisch aus polymerem Bindemittel, mindestens einer ethylenisch ungesättigten polymerisierbaren Verbindung, Photoinitiator und thermischem Polymerisationsinhibitor besteht, die dadurch gekennzeichnet ist, daß in der reliefbildenden photopolymerisierbaren Schicht als polymeres Bindemittel ein wasserlösliches Copolymer des Polyvinylalkohols oder ein wasserlösliches Derivat des Polyvinylalkohols und als ethylenisch ungesättigte polymerisierbare Verbindung eine Verbindung der allgemeinen Formel (I) 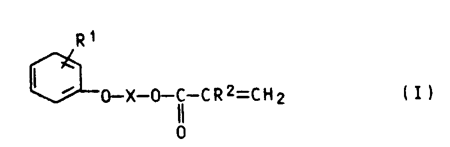
worin R¹ für Wasserstoff, einen Alkylrest mit 1 bis 10 Kohlenstoffatomen oder einen Arylrest mit 6 bis 10 Kohlenstoffatomen,
R² für Wasserstoff oder einen Methylrest,
und X für -(CH₂-CH₂-O)ₙ-C₂H₄-, -C₂H₄-,
-(CHCH₃-CH₂-O)ₙ-CHCH₃-CH₂- , 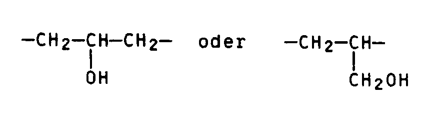
und n = 0 bis 8 stehen,
enthält.

Als R¹ kommt außer Wasserstoff beispielsweise ein Alkylrest mit 1 bis 10 Kohlenstoffatomen, wie z.B. ein Methyl-, Ethyl-, n-Propyl-, Isopropyl-, n-Butyl-, Isobutyl-, tert.-Butyl-, Pentyl-, Hexyl-, n-Octyl-, Isooctylrest oder ein Arylrest, wie z.B. ein Phenyl- oder Naphthylrest in Frage.

Dabei kann auch eine Zwischenschicht der Druckplatte eine Verbindung der allgemeinen Formel (I) in polymerisiertem Zustand enthalten oder es kann auf dem dimensionsstabilen Träger als erste Zwischenschicht eine dünne Schicht eines üblichen Haftvermittlers und darauf eine zweite Zwischenschicht vorhanden sein, die eine Verbindung der allgemeinen Formel (I) im Gemisch mit polymerem Bindemittel in polymerisiertem Zustand enthält.

Die reliefbildende photopolymerisierbare Schicht der erfindungsgemäßen Druckplatte kann auch mit einer abziehbaren Schutzfolie bedeckt sein.

Bevorzugte Verbindungen der Formel (I) sind solche, in denen R¹ für Methyl oder Wasserstoff und X für den Rest 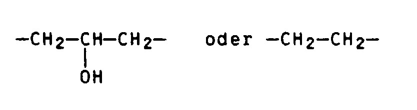
stehen.

Als wasserlösliches Copolymer des Polyvinylalkohols kann vorzugsweise ein zumindest teilweise verseiftes Pfropfpolymerisat von Vinylestern, insbesondere von Vinylacetat, auf Polyethylenoxid eingesetzt werden. Als wasserlösliches Derivat des Polyvinylalkohols kann vorzugsweise ein mit Methacrylsäureanhydrid teilweise veresterter Polyvinvlalkohol und/oder ein teilacetalisierter Polyvinylalkohol eingesetzt werden.

Gegenstand der vorliegenden Erfindung ist auch eine Druckplatte der vorstehenden Art, die zusätzlich ein sogenanntes "sensitometrisches Reglersystem" enthält, wobei die reliefbildende photopolymerisierbare Schicht vorzugsweise mindestens einen Photoinitiator, der bei der Belichtung mit aktinischem Licht eine rasche Photopolymerisation in der Schicht auslöst, sowie in bekannter Weise eine bei Belichtung mit aktinischem Licht keine merkliche Photopolymerisation in der Schicht auslösende Kombination eines löslichen Farbstoffs mit einem Reduktionsmittel für diesen Farbstoff enthält, wobei das Reduktionsmittel den Farbstoff in Abwesenheit von aktinischem Licht nicht reduziert, bei Belichtung jedoch den Farbstoff im angeregten Elektronenzustand zu reduzieren vermag, wie es beispielsweise in EP-A-114 341 beschrieben wird.

Mit den erfindungsgemäßen photopolymerisierbaren Druckplatten gelingt es, auf einfache und vorteilhafte Weise Druckformen mit im Flexodruck üblicher Klischeehärte und Elastizität herzustellen, die sich insbesondere auch für den Druck auf rauhe Bedruckstoffe eignen.

Zu den Aufbaukomponenten der erfindungsgemäßen Druckplatten ist im einzelnen folgendes auszuführen.

Als dimensionsstabile Träger kommen die üblichen, an sich bekannten dimensionsstabilen, starren oder vorzugsweise flexiblen Schichtträger in Betracht, wobei die Art des Schichtträgers auch vom Verwendungszweck mitbestimmt wird. Beispielsweise eignen sich metallische Schichtträger, z.B. aus Aluminium-, Magnesium-, Kupfer-, Zink-, Stahl- oder Mehrmetallplatten, die als solche oder in mechanisch, chemisch, elektrochemisch und/oder durch Versehen mit einem Haftlack vorbehandelter Form eingesetzt werden können. Geeignet als Träger sind auch Polymerfilme mit metallisierter Oberfläche, wie Aluminium-bedampfte Polyethylenterephthalat-Filme. Bevorzugt als Träger sind Aluminiumbleche oder -Folien sowie dimenssionsstabile Kunststoff-Folien, insbesondere Polyesterfolien, wie Polyethylenterephthalat-Folien. Diese dimensionsstabilen Träger haben im allgemeinen Dicken von ca. 0,08 bis 0,3 mm.

Zwischen Träger und reliefbildender photopolymerisierbarer Schicht sind eine oder mehrere Zwischenschichten vorhanden.

So kann beispielsweise auf den Träger eine Haftvermittler- oder Haftlackschicht angebracht sein, die thermisch vernetzt ist. Geeignete Haftlackschichten sind z.B. solche auf Basis eines Gemisches aus Polyol und Polyisocyanat, die im allgemeinen eine Schichtdicke von 1 bis 100, vorzugsweise 5 bis 50 »m aufweisen. Derartige Haftlackschichten sind beispielsweise in DE-A-1 597 515, DE-A-2 202 357, EP-A-53 259 und EP-A-53 258 beschrieben.

Anstelle derartiger üblicher Haftlackschichten, deren qualitative und quantitative Zusammensetzung im allgemeinen der Art des Trägermaterials und der Zusammensetzung der reliefbildenden Schicht oder einer weiteren Zwischenschicht angepaßt ist, kann der Träger auch mit einer dünnen Schicht einer Verbindung der Formel (I), vorzugsweise des Phenylglycidylether(meth)acrylats, dem etwas (Photo-)Polymerisationsinitiator beigemischt ist, überzogen und dann thermisch oder durch Belichtung bzw. Bestrahlung polymerisiert werden, wodurch im allgemeinen Haftschichten von 1 bis 100 »m auf dem Träger gebildet werden.

Als weitere, zwischen auf dem Träger angebrachter Haftschicht und reliefbildender photopolymerisierbarer Schicht angeordnete Zwischenschicht eignen sich Gemische aus polymerem Bindemittel und polymerisierbaren ethylenisch ungesättigten Verbindungen, vorzugsweise einer Verbindung der allgemeinen Formel (I), die Polymerisationsinitiatoren bzw. Photopolymerisationsinitiatoren sowie gegebenenfalls weitere übliche Zusatzstoffe, wie Farbstoffe, Weichmacher, Regler und thermische Inhibitoren enthalten, und vor Applikation der photopolymerisierbaren reliefbildenden Schicht thermisch bzw. durch Bestrahlung polymerisiert werden. Derartige Zwischenschichten können 1 bis 200, vorzugsweise 5 bis 100 »m dick sein. Für derartige Zwischenschichten kommen als polymere Bindemittel z.B. die in der Reliefschicht verwendeten wasserlöslichen Polymeren, aber auch z.B. Polyvinylacetate oder Polyvinylacetale und als polymerisierbare ethylenisch ungesättigte Verbindungen z.B. Arylglycidyletheracrylate oder -methacrylate oder Phenoxyethylacrylat oder Mischungen dieser Monomeren mit anderen polymerisierbaren Monomeren, wie z.B. mono- oder polyfunktionellen (Meth)acrylsäureestern in Frage.

Die photopolymerisierbare reliefbildende Schicht besteht erfindungsgemäß aus einem Gemisch aus einem polymeren Bindemittel, mindestens einer ethylenisch ungesättigen polymerisierbaren Verbindung, mindestens einem Photoinitiator und einem Polymerisationsinhibitor, wobei das polymere Bindemittel ein wasserlösliches Vinylalkoholcopolymer oder ein Derivat des Polyvinylalkohols sein kann und als ethylenisch ungesättigte polymerisierbare Verbindung eine Verbindung der allgemeinen Formel (I), vorzugsweise ein Arylglycidyl(meth)acrylat dient. Die Mitverwendung weiterer ethylenisch ungesättigter copolymerisierbarer insbesondere auch polyfunktioneller Verbindungen ist für die Erzielung befriedigender Ergebnisse nicht erforderlich. Für die Einstellung bestimmter Eigenschaften, z.B. abgestufter Klischeehärte, kann die Mitverwendung weiterer, auch polyfunktioneller copolymerisierbarer Verbindungen von Vorteil sein. Als weitere derartige copolymerisierbare ethylenisch ungesättigte Verbindungen kommen in Frage eine oder mehrere Verbindungen mit mindestens einer photopolymerisierbaren olefinisch ungesättigten Doppelbindung. Hierbei lassen sich die bekannten, für die Herstellung von Reliefformen und Photopolymerhoch-, -tief- und -offset-druckplatten verwendeten Monomeren, Oligomeren und ungesättigten Polymeren verwenden, deren Art sich nach dem Verwendungszweck der Mischungen, aber auch nach der Art der anderen Mischungskomponenten richtet. In Frage kommen Monomere mit zwei oder mehr olefinisch ungesättigten photopolymerisierbaren Doppelbindungen allein oder in Mischung mit Monomeren mit nur einer olefinisch ungesättigten photopolymerisierbaren Doppelbindung. Auch Polymere mit mehreren seiten- oder endständigen olefinisch ungesättigten Doppelbindungen sind anstelle von oder in Mischung mit den Monomeren verwendbar. Beispiele geeigneter Monomerer sind die Di- und Polyacrylate und -methacrylate, wie sie durch Veresterung von Diolen oder Polyolen mit Acrylsäure oder Methacrylsäure hergestellt werden können; wie die Di- und Tri(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Neopentylglykol, (2,2-Dimethylpropandiol), 1,4-Butandiol, 1,1,1-Trimethylolpropan, Glycerin oder Pentaerythrit, ferner die Monoacrylate und Monomethacrylate solcher Diole und Polyole, wie z.B. Ethylenglykol-, Di-, Tri- oder Tetraethylenglykolmonoacrylat, Monomere mit zwei- oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen. Genannt seien auch Acrylsäure, Methacrylsäure sowie deren Derivate wie (Meth)acrylamid, N-Hydroxymethyl(meth)acrylamid oder die (Meth)acrylate von Monoalkoholen mit 1 bis 6 C-Atomen.

Geeignete Monomere sind außerdem Umsetzungsprodukte von Glycidylethern mit Acrylsäure oder Methacrylsäure, wie z.B. Umsetzungsprodukte von Bisphenol-A-diglycidylether oder Butandioldiglycidylether mit Acrylsäure oder Methacrylsäure.

Die ethylenisch ungesättigte copolymerisierbare Verbindung der allgemeinen Formel (I) oder das Gemisch dieser Verbindung mit einer oder mehreren weiteren ethylenisch ungesättigten Verbindungen der oben genannten Art werden im allgemeinen in Mengen von 10 bis 70, vorzugsweise 30 bis 60 Gew.%, bezogen auf Gesamtmenge aus polymerem Bindemittel und photopolymerisierbaren Monomeren in der reliefbildenden Schicht eingesetzt.

Als polymeres Bindemittel kommen erfindungsgemäß wasserlösliche Vinylalkoholcopolymere und/oder wasserlösliche Derivate des Polyvinylalkohols in Betracht. Beispiele derartiger geeigneter polymerer Bindemittel sind in wäßrigen Lösungsmitteln lösliche oder dispergierbare elastomere Pfropfpolymerisate, die durch Polymerisation von Vinylestern in Gegenwart von Polyalkylenoxiden und einem Initiator der radikalischen Polymerisation, Verseifen oder Teilverseifen des resultierenden Pfropfcopolymerisats und gegebenenfalls anschließendes Verestern oder Umestern von Vinylalkohol-Einheiten des verseiften oder teilverseiften Pfropfcopolymerisats hergestellt sind und im wesentlichen bestehen aus Struktureinheiten der Zusammensetzung 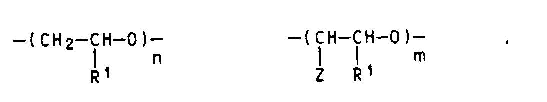
worin Z: aufgepfropfte Seitenzweige mit Struktureinheiten 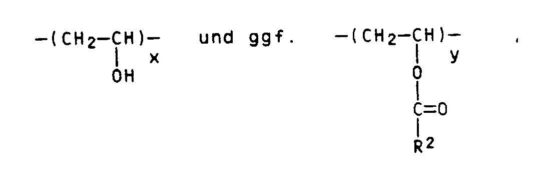
R¹ Wasserstoff und/oder Alkylreste mit 1 oder 2 C-Atomen,
R² Alkyl- und/oder Alkenylreste, gegebenenfalls mit Carboxylsubstituenten, darstellen,
und x > y, n > m, m mindestens 2, n + m = 20-2000, und 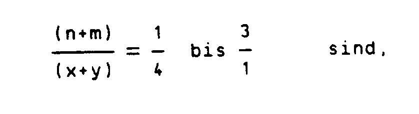
wie sie in EP-A-224 164 beschrieben sind.

Ebenso eignen sich mit Methacrylsäure teilweise veresterte Polyvinylalkohole, wie sie in EP-A-220 507 beschrieben sind, sowie teilacetalisierter Polyvinylalkohol.

Derartige geeignete Polyvinylalkohole weisen im allgemeinen Molekulargewichte M̅ₙ zwischen etwa 4 000 und 100 000, vorzugsweise 10 000 und 70 000 auf. Das polymere Bindemittel ist in den erfindungsgemäßen photopolymerisierbaren reliefbildenden Schichten im allgemeinen in Mengen von 30 bis 90, vorzugsweise 40 bis 70 Gew.%, bezogen auf Gesamtmenge aus polymerem Bindemittel und photopolymerisierbaren Monomeren vorhanden.

Die erfindungsgemäßen photopolymerisierbaren reliefbildenden Schichten enthalten in üblicher Weise zusätzlich mindestens einen Photoinitiator, im allgemeinen in Mengen von 0,01 bis 10 und insbesondere 0,01 bis 3 Gew.%, bezogen auf die Gesamtmenge der photopolymerisierbaren Schicht. Als Photoinitiatoren sind dabei solche Verbindungen geeignet, die bei Einwirkung von aktinischem Licht Radikale zu bilden vermögen und eine rasche Photopolymerisation in der Schicht auslösen. Als Photoinitiatoren kommen z.B. in Frage Acyloine und Acyloinether, aromatische Diketone und deren Derivate und mehrkernige Chinone. Sehr geeignet sind Benzoin- und α-Hydroxymethylbenzoin und besonders deren Alkylether mit 1 bis 8 C-Atomen wie Benzoin-isopropylether, α-Hydroxymethyl-benzoinmethylether oder Benzoinmethylether, Benzilmonoketale wie Benzil-dimethylketal, Benzil-methyl-ethylketal, Benzil-methyl-benzylketal, Benzil-neopentylketal oder Diarylphosphinoxide, wie sie in der DE-OS 29 09 992 beschrieben sind, vorzugsweise 2,6-Dimethoxybenzoyldiphenylphosphinoxid und insbesondere 2,4,6-Trimethylbenzoyl-diphenylphosphinoxid. Bevorzugt sind Photoinitiatoren in Art und Menge, daß sie für die Auslösung der Photopolymerisation bei bildmäßiger Belichtung mit aktinischem Licht, insbesondere UV-Licht, nur kurze Mindestbelichtungszeiten, bevorzugt nicht mehr als wenige Minuten, benötigen.

Die erfindungsgemäßen photopolymerisierbaren reliefbildenden Schichten enthalten außerdem zweckmäßigerweise auch Inhibitoren gegen die thermische Polymerisation, wie Hydrochinon, p-Methoxyphenol, Dinitrobenzol, p-Chinon, Methylenblau, β-Naphthol, N-Nitrosamine wie N-Nitrosodiphenylamin, Phenothiazin, Phosphorigsäureester wie Triphenylphosphit oder die Salze und insbesondere die Alkali- und Aluminiumsalze des N-Nitroso-cyclohexylhydroxylamins. Die Inhibitoren werden den photopolymerisierbaren Mischungen der reliefbildenden polymerisierbaren Schicht im allgemeinen in einer Menge von 0,001 bis 3 Gew.% und insbesondere in einer Menge von 0,003 bis 1 Gew.%, bezogen auf die Gesamtmenge der polymerisierbaren Schicht, zugemischt.

In bekannter Weise können natürlich auch weitere übliche Zusätze mitverwendet werden, wie Weichmachner, gesättigte niedermolekulare Verbindungen mit Amid- oder Alkoholgruppen, Wachse, Pigmente usw.

Gemäß einer besonders vorteilhaften Ausführungsform der vorliegenden Erfindung kann die photopolymerisierbare Schicht noch ein Reglersystem enthalten, wie es beispielsweise in EP-A-114 341 beschrieben ist.

Dies sind Mischungen bestimmter Farbstoffe (1) mit milden Reduktionsmitteln (2) für den mitverwendeten jeweiligen Farbstoff (1) [vgl. auch EP-A-0 114 341). Die Mischung (1) + (2) soll bei der bildmäßigen Belichtung mit aktinischem Licht keine merkliche Photopolymerisation in der Schicht der photopolymerisierbaren Mischung auslösen, was mit wenigen Versuchen feststellbar ist. Beträgt z.B. die Belichtungszeit für erfindungsgemäße, bevorzugt im wesentlichen lösungsmittelfreie, Schichten der photopolymerisierbaren, den Photoinitiator enthaltenden Mischung X Stunden oder Minuten, so sollte die entsprechende Schicht, die den Photoinitiator nicht enthält, mit Vorteil auch bei Anwendung der zehnfachen Belichtungszeit beim anschließenden Entwickeln der Reliefform durch Auswaschen keine merklichen Anteile an photopolymerisierter Schicht aufweisen, im allgemeinen sollten weniger als 20 Gew.% der belichteten Monomerenmengen photopolymerisiert sein.

Als Farbstoffe (1) für die photopolymerisierbaren Mischungen eignen sich vor allem solche aus der Reihe der Phenoxazinfarbstoffe, wie z.B.

Capriblau GN (C.I. 51000), Zaponechtblau 3 G (C.I. 51005), Galloblau E (C.I. 51040), Echtneublau 3 R (C.I. 51175), Nilblau A (C.I. 51180), Echtgrün M (C.I. 51210), Echtschwarz L (C.I. 51215), sowie Rhodanilblau, dem Salz bzw. Amid aus Rhodamin B (Basic Violet 10, C.I. 45170) und Nilblau (Basic Blue 12, C.I. 51180), Verbindungen aus der Reihe der Phenaziniumfarbstoffe, wie z.B. Neutralrot (C.I. 50040), Neutralviolett (C.I. 50030), Azinscharlach G (C.I. 50045), Rhodulinheliotrop 3 B (C.I. 50055), Neutralblau C (C.I. 50150), Azingrün GB (C.I. 50155), Safranin B (C.I. 50200), Indaminblau B (C.I. 50204), Rhodulinrot G (C.I. 50215), Rhodulinblau GG extra (C.I. 50220), Indazin GB (C.I. 50221), Safranin T (C.I. 50240), Mauvein (C.I. 50245), Naphthylrot (C.I. 50370) sowie Nigroinschwarz T (C.I. 50415), Acridiniumfarbstoffe, wie z.B. Acriflavin (C.I. 46000), Acridinorange (C.I. 46005), Acridinscharlach J (C.I. 46015), Acridingelb G (C.I. 46025), Aurazin G (C.I. 46030), Diamantphosphin GG (C.I. 46035), Phosphin E (C.I. 46045), Flaveosin (C.I. 46060), Benzoflavin (C.I. 46065) und Rheonin A (C.I. 46075), ferner Phenothiaziniumfarbstoffe, wie z.B. Methylenblau oder Thionin. Ebenso eignet sich (Isobutylthio)anthrachinon als Farbstoff (1).

Die Auswahl des in der photopolymerisierbaren Mischung verwendeten Farbstoffs (1) wird vor allem vom ästhetischen Eindruck mitbestimmt. So ist z.B. eine visuelle Beurteilung der Druckplatten besonders einfach mit den Verbindungen Neutralrot (C.I. 50040), Safranin T (C.I. 50240) sowie Rhodanilblau, die bevorzugt in der photopolymerisierbaren Mischung verwendet werden.

Die erfindungsgemäßen Schichten können also in Kombination mit dem Farbstoff (1) eine für diesen hinreichende Menge eines Reduktionsmittels (2) für den Farbstoff (1) enthalten, das den mitverwendeten Farbstoff (1) in Abwesenheit von aktinischem Licht nicht reduziert, bei Belichtung den Farbstoff im angeregten Elektronenzustand jedoch reduzieren kann, insbesondere zum Semichinon. Beispiele solcher milden Reduktionsmittel sind Ascorbinsäure, Anethol, Thioharnstoff, Diethylallylthioharnstoff, Hydroxylamin-derivate, insbesondere N-Allylthioharnstoff und bevorzugt Salze des N-Nitrosocyclohexyl-hydroxylamins, insbesondere die Kalium- und Aluminiumsalze. Letztere sind auch als Inhibitoren gegen die thermische Polymerisation in photopolymerisierbaren Mischungen bekannt. Die Menge der zugesetzten Reduktionsmittel beträgt im allgemeinen etwa 0,005 bis 5 und insbesondere 0,01 bis 1 Gew.%, bezogen auf die Gesamtmenge der photopolymerisierbaren Schicht, soll jedoch nicht weniger als das Reduktionsäquivalent der Menge des verwendeten Farbstoffs (1) betragen. In vielen Fällen hat sich der Zusatz des 3- bis 10-fachen der Menge an mitverwendetem Farbstoff (1) bewährt.

Die Herstellung der photopolymerisierbaren Druckplatten erfolgt im allgemeinen durch Aufbringen einer homogenen Mischung der Komponenten der photopolymerisierbaren Reliefschicht, gegebenenfalls unter Zusatz von Lösungsmittel odere Lösungsmittelgemischen auf einen dimensionsstabilen Träger, der zweckmäßigerweise vorher mit einer oder mehreren haftvermittelnden Schichten versehen wurde.

Das homogene photopolymerisierbare Gemisch läßt sich auf übliche Weise durch Mischen der Einzelkomponenten in üblichen Mischaggregaten, beispielsweise in Knetern, Extrudern oder Rührkesseln herstellen. Das homogene Gemisch wird dann im allgemeinen in einer Dicke von 25 bis 6000, vorzugsweise 200 bis 1000 »m auf den mit der Haftschicht bzw. mit einer oder mehreren Zwischenschichten versehenen dimensionsstabilen Träger aufgebracht.

Es kann auch vorteilhaft sein, auf die photopolymerisierbare reliefbildende Schicht noch eine Deck- bzw. Schutzschicht aufzubringen, z.B. eine dünne Schicht aus im Entwicklermedium löslichen Polymeren, wie z.B. Polyvinylalkohol oder Polyvinvlalkohol-Polyethylenoxid-Copolymerisate.

Die erfindungsgemäßen photopolymerisierbaren Druckplatten lassen sich in bekannter Weise zu Reliefformen, insbesondere Druckformen, verarbeiten. Hierzu wird im allgemeinen die Schicht des photoempfindlichen Materials bildmäßig mit aktinischem Licht aus Lichtquellen, wie UV-Fluoreszenzröhren, Quecksilberhoch-, -mittel- oder -niederdruckstrahlern, Leuchtstoffröhren etc. belichtet, wobei die emittierte Wellenlänge bevorzugt zwischen 300 und 420 nm liegt. Das Entfernen der unbelichteten und unvernetzten Schichtanteile kann durch Sprühen, Waschen, Bürsten etc. mit wäßrigen Lösungsmitteln oder Wasser erfolgen. Es ist ein Vorteil der erfindungsgemäßen Druckplatten, daß sie ein Auswaschen der unbelichteten Schichtteile mit reinem Wasser ohne Zusatz organischer Lösungsmittel erlauben. Zweckmäßig werden entwickelte Relief- und Druckformen bei Temperaturen bis zu 120°C getrocknet und gegebenenfalls gleichzeitig oder danach mit aktinischem Licht nachbelichtet.

Die aus erfindungsgemäßen Aufzeichnungsmaterialien hergestellten Druckformen eignen sich besonders für den Flexodruck, Zeitungsflexodruck und ähnliche Druckarten.

Die erfindungsgemäßen Druckplatten, die in der reliefbildenden Schicht eine Verbindung der allgemeinen Formel (I), insbesondere Phenylglycidylether(meth)acrylat als photopolymeriserbare ethylenische ungesättigte Verbindung enthalten, lassen sich sehr vorteilhaft herstellen und zu Druckformen verarbeiten, die hohe Elastizität bei geringer Härte aufweisen.

Die Erfindung wird durch die nachstehenden Beispiele erläutert. Die darin genannten Teile und Prozente beziehen sich, soweit nicht anders angegeben, auf das Gewicht. Volumenteile verhalten sich zu Teilen wie Liter zu Kilogramm.

Die Messung der Klischeehärte erfolgte mittels einer Apparatur zur Bestimmung der Brinellhärte (nach DIN 53 456) unter Belastung (Filmhärtebestimmungsapparatur nach Pfund) durch Ausmessen der Eindringtiefe einer Quarzkugel mit einem Durchmesser von 5,926 mm.

### Beispiel 1

Durch thermische Polymerisation von 3 Teilen Vinylacetat in Gegenwart von 2 Teilen Polyethylenoxid mit einer mittleren Molmasse von 35 000 g/mol und anschließende Umesterung in methanolischer Natronlauge wird, wie in EP-A-224 164 beschrieben, ein Pfropfcopolymerisat erhalten. Aus 55 Teilen dieses Pfropfcopolymerisats, 45 Teilen Phenylglycidyletheracrylat (= Umsetzungsprodukt aus Phenylglycidylether und Acrylsäure), 1,5 Teilen Benzyldimethylketal, 0,5 Teilen Kaliumsalz des N-Nitrosocyclohexylhydroxylamins, 0,05 Teilen Safranin T (C.I. 50 240), 50 Teilen Wasser und 50 Teilen Methanol wird durch Rühren bei 60°C eine Losung hergestellt.

Die Lösung wird auf ein mit einem Haftlack versehenes Stahlblech aufgegossen und so abgerakelt, daß nach dem Trocknen eine Schicht der photopolymerisierbaren Mischung von 500 »m Dicke entsteht. Die so erhaltene Druckplatte wird 4 Minuten mit aktinischem Licht durch ein Negativ belichtet und 2 Minuten bei 20°C in einem handelsüblichen Sprühwascher mit Wasser entwickelt. Nach dem Trocknen erhält man eine elastische Druckform mit glatter, klebfreier Oberfläche, sehr gut ausgebildetem Relief und einer Brinell-Härte (nach DIN 53 456) von 10 cN/mm².

### Beispiel 2

Aus einer Losung von 10 Teilen eines partiell hydrolysierten Polyvinylacetats (Polymerisationsgrad 400, Verseifungsgrad 80 mol.%), dessen freie Hydroxylgruppen mit 5 mol.% Acrylsaure verestert wurden, 50 Teile eines Polyethylenoxid-Polyvinylalkohol-Pfropfcopolymerisats (z.B. Mowiol® 04-M1 der Firma Hoechst), 40 Teilen Phenylglycidyletheracrylat, 1,2 Teilen Benzildimethylketal, 0,5 Teilen Kaliumsalz des N-Nitrosocyclohexylhydroxylamins und 0,05 Teilen Safranin T in 50 Teilen Wasser und 50 Teilen Methanol wird, wie in Beispiel 1 beschrieben, eine Druckplatte hergestellt.

Nach bildmäßigem Belichten, Entwickeln in Wasser und Trocknen erhält man eine elastische Druckform mit glatter Oberfläche, sehr gut ausgebildetem Relief und einer Brinell-Härte von 35 cN/mm².

### Beispiel 3

Aus einer Lösung von 10 Teilen eines partiell hydrolysierten Polyvinylacetats (Polymerisationsgrad 400, Verseifungsgrad 80 mol.%), dessen freie Hydroxylgruppen mit 5 mol.% Acrylsäure verestert wurden, 50 Teile des in Beispiel 1 beschriebenen Polyethylenoxid-Polyvinylalkohol-Pfropfcopolymerisats, 40 Teilen Phenylglycidyletheracrylat, 1,2 Teilen Benzildimethylketal, 0,5 Teilen Kaliumsalz des N-Nitrocyclohexylhydroxylamins und 0,05 Teilen Safranin T in 50 Teilen Wasser und 50 Teilen Methanol wird, wie in Beispiel 1 beschrieben, eine Druckplatte hergestellt.

Nach bildmäßigem Belichten, Entwickeln in Wasser und Trocknen erhält man eine gummielastische Druckform mit gut ausgebildetem Relief und einer Brinell-Härte von 14 cN/mm².

### Beispiel 4

Eine wie unter Beispiel 1 beschriebene Lösung einer photopolymerisierbaren Mischung wird auf eine mit einer 2 »m dicken Schicht Polyvinylalkohol versehene Polyesterfolie gegossen und so abgerakelt, daß nach dem Trocknen eine 500 »m dicke photopolymerisierbare Schicht entsteht. Auf ein durch Waschen mit Aceton entfettetes Aluminiumblech wird Phenylglycidyletheracrylat, das 2 % Benzildimethylketal gelöst enthält, so aufgetragen, daß nach dem Belichten mit aktinischem Licht eine 50 »m dicke Schicht des polymerisierten Acrylats entsteht.

Durch Kaschieren der photopolymeren Schicht mit dem so präparierten Träger, unter Verwendung einer Mischung von Ethanol und Wasser im Verhältnis 1:1, und Abziehen der Polyesterfolie, wird eine Druckplatte hergestellt, aus der nach dem oben beschriebenen Verfahren Druckformen mit ausgezeichneter Haftung zwischen Reliefschicht und Träger erhalten werden.

### Beispiel 5

Es wird verfahren wie unter Beispiel 3 beschrieben, jedoch wird anstelle des Aluminiumblechs eine 0,2 mm dicke Polyethylenterephthalatfolie als Träger verwendet. Auch hier werden Druckformen mit ausgezeichneter Haftung zum Träger erhalten.

### Vergleichsbeispiel 1

Aus einer Lösung von 25 Teilen eines Polyethylenoxid-Polyvinylalkohol-Pfropfcopolymeren (z.B. Mowiol 04-M1 der Firma Hoechst AG), dessen freie Hydroxylgruppen mit 4 mol.% Acrylsaure verestert wurden, 45 Teilen eines, wie unter Beispiel 1 beschrieben, hergestellten Pfropfcopolymerisats, 30 Teilen Ethylenglykoldimethacrylat, 1,2 Teilen Benzildimethylketal, 0,5 Teilen Kaliumsalz des N-Nitrosocyclohexylhydroxylamins und 0,05 Teilen Safranin T in 50 Teilen Wasser und 50 Teilen Methanol wird wie in Beispiel 1 beschrieben eine Druckplatte hergestellt.

Zur Herstellung einer Druckform aus der so hergestellten Rohplatte ist eine Belichtungszeit von mehr als 25 Minuten notwendig.

Man erhält harte, spröde Klischees mit rauher Oberfläche und schlecht ausgebildeter Reliefschicht.

## Patentansprüche

1. Photopolymerisierbare, zur Herstellung weichelastischer Druckformen geeignete Druckplatte, die auf einem dimensionsstabilen Träger mindestens eine Zwischenschicht und darauf eine reliefbildende photopolymerisierbare Schicht trägt, die im wesentlichen aus einem Gemisch aus polymerem Bindemittel, mindestens einer ethylenisch ungesättigten polymerisierbaren Verbindung, Photoinitiator und thermischem Polymerisationsinhibitor besteht, dadurch gekennzeichnet, daß in der reliefbildenden photopolymerisierbaren Schicht als polymeres Bindemittel ein wasserlösliches Copolymer des Polyvinylalkohols oder ein wasserlösliches Derivat des Polyvinylalkohols und als ethylenisch ungesättigte polymerisierbare Verbindung eine Verbindung der allgemeinen Formel (I) 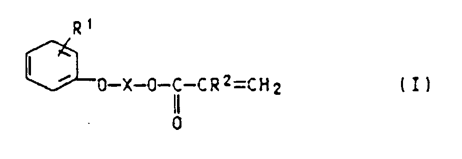 worin R¹ für Wasserstoff, einen Alkylrest mit 1 bis 10 Kohlenstoffatomen oder einen Arylrest mit 6 bis 10 Kohlenstoffatomen,
R² für Wasserstoff oder einen Methylrest,
und X für -(CH₂-CH₂-O)ₙ-C₂H₄-, -C₂H₄-,
-(CHCH₃-CH₂-O)ₙ-CHCH₃-CH₂-, 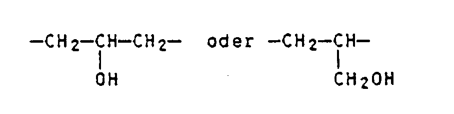 und n = 0 bis 8 stehen,
enthalten ist.

2. Druckplatte nach Anspruch 1, dadurch gekennzeichnet, daß mindestens eine Zwischenschicht der Druckplatte eine Verbindung der allgemeinen Formel (I) in polymerisiertem Zustand enthält.

3. Druckplatte nach Anspruch 1, dadurch gekennzeichnet, daß auf dem dimensionsstabilen Träger als erste Zwischenschicht eine dünne Schicht eines üblichen Haftvermittlers und darauf eine zweite Zwischenschicht vorhanden ist, die eine Verbindung der allgemeinen Formel (I) im Gemisch mit polymerem Bindemittel in polymerisiertem Zustand enthält.

4. Druckplatte nach einem der vorhergehenden Ansprüche, dadurch gekennzeichnet, daß die reliefbildende photopolymerisierbare Schicht mit einer abziehbaren Schutzfolile bedeckt ist.

5. Druckplatte nach einem der vorhergehenden Ansprüche, dadurch gekennzeichnet, daß in der Formel (I) R¹ für Wasserstoff oder Methyl und X für den Rest 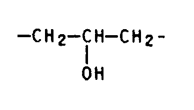 stehen.

6. Druckplatte nach einem der vorhergehenden Ansprüche, dadurch gekennzeichnet, daß als wasserlösliches Copolymer des Polyvinylalkohols ein zumindest teilweise verseiftes Pfropfcopolymerisat eines Vinylesters auf Polyethylenoxid eingesetzt wird.

7. Druckplatte nach einem der Ansprüche 1 bis 5, dadurch gekennzeichnet, daß als wasserlösliches Derivat des Polyvinylalkohols ein mit Methacrylsäure teilweise veresterter Polyvinylalkohol und/oder ein teilacetalisierter Polyvinylalkohol eingesetzt wird.

8. Druckplatte nach einem der vorhergehenden Ansprüche, dadurch gekennzeichnet, daß die reliefbildende photopolymerisierbare Schicht mindestens einen Photoinitiator, der bei der Belichtung mit aktinischem Licht eine rasche Photopolymerisation in der Schicht auslöst, sowie in bekannter Weise eine bei Belichtung mit aktinischem Licht keine merkliche Photopolymerisation in der Schicht auslösende Kombination eines Farbstoffes mit einem Reduktionsmittel für diesen Farbstoff enthält, das den Farbstoff in Abwesenheit von aktinischem Licht nicht reduziert, bei Belichtung den Farbstoff im angeregten Elektronenzustand jedoch zu reduzieren vermag.

## Claims

1. A photopolymerizable laminate suitable for producing flexible and resilient printing plates which on a dimensionally stable base carries at least one intermediate layer and on top thereof a relief-forming photopolymerizable layer which consists essentially of a mixture of polymeric binder, at least one ethylenically unsaturated polymerizable compound, photoinitiator and thermal polymerization inhibitor, wherein in the relief-forming photopolymerizable layer the polymeric binder is a water-soluble copolymer of polyvinyl alcohol or a water-soluble derivative of polyvinyl alcohol and the ethylenically unsaturated polymerizable compound is a compound of the general formula (I) 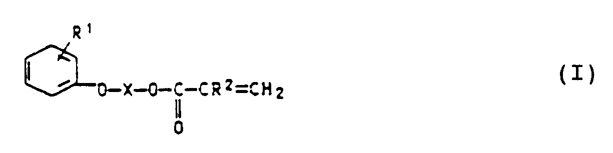 where R¹ is hydrogen or alkyl of from 1 to 10 carbon atoms or aryl of from 6 to 10 carbon atoms, R² is hydrogen or methyl, X is
-(CH₂-CH₂-O)ₙ-C₂H₄-, -C₂H₄-,
-(CHCH₃-CH₂-O)ₙ-CHCH₃-CH₂-, 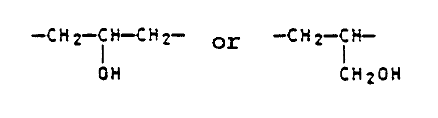 and n is from 0 to 8.

2. A laminate as claimed in claim 1, wherein at least one intermediate layer contains a compound of the general formula (I) in the polymerized state.

3. A laminate as claimed in claim 1, wherein there are present on the dimensionally stable base as a first intermediate layer a thin layer of a customary adhesion promoter and on top thereof a second intermediate layer which contains a compound of the general formula (I) mixed with a polymeric binder in the polymerized state.

4. A laminate as claimed in any of the preceding claims, wherein the relief-forming photopolymerizable layer has been covered with a cover sheet removable by peeling.

5. A laminate as claimed in any of the preceding claims, wherein in the formula (I) R¹ is hydrogen or methyl and X is the radical

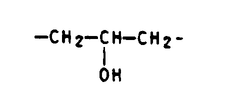

6. A laminate as claimed in any of the preceding claims, wherein the water-soluble copolymer of polyvinyl alcohol is an at least partially hydrolyzed graft copolymer of a vinyl ester on polyethylene oxide.

7. A laminate as claimed in any of claims 1 to 5, wherein the water-soluble derivative of polyvinyl alcohol is a polyvinyl alcohol partially esterified with methacrylic acid and/or a partially acetalated polyvinyl alcohol.

8. A laminate as claimed in any of the preceding claims, wherein the relief-forming photopolymerizable layer contains at least one photoinitiator which on irradiation with actinic light initiates rapid photopolymerization in the layer and, in a conventional manner, a combination, which on irradiation with actinic light does not initiate any noticeable photopolymerization in the layer, of a dye with a reducing agent for this dye which does not reduce the dye in the absence of actinic light but on irradiation is capable of reducing the dye in the excited state.

## Revendications

1. Plaque d'impression photopolymérisable convenant pour la préparation de formes d'impression à élasticité molle, qui porte, sur un support stable en dimension, au moins une couche intermédiaire et sur elle une couche photopolymérisable formant relief, qui est constituée essentiellement d'un mélange de liant polymère, d'au moins un composé polymérisable insaturé éthyléniquement, photoinitiateur et inhibiteur de polymérisation thermique, caractérisé par le fait que dans la couche polymérisable formant relief est contenu, comme liant polymère, un copolymère soluble dans l'eau du polyalcool vinylique ou un dérivé soluble dans l'eau du polyalcool vinylique et, comme composé polymérisable insaturé éthyléniquement, un composé de la formule générale I 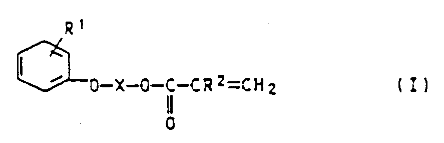 où
R¹ est mis pour hydrogène, un reste alkyle en C1-C10 ou un reste aryle en C6-C10
R² est mis pour hydrogène ou un reste méthyle et
X par -(CH₂-CH₂-O)ₙ-C₂H₄-, -C₂H₄-,
-(CHCH₃-CH₂-O)ₙ-CHCH₃-CH₂-, 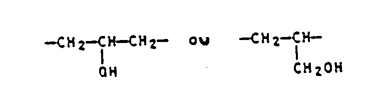
et n = 0 à 8

2. Plaque d'impression selon la revendication 1, caractérisé par le fait qu'au moins une couche intermédiaire de la plaque contient un composé de la formule générale (I) à l'état polymérisé.

3. Plaque d'impression selon la revendication 1, caractérisa par le fait que sur le support de dimension stable est prévue, comme première couche intermédiaire, une couche mince d'un intermédiaire d'adhérence usuel et là-dessus une deuxième couche intermédiaire qui contient à l'état polymérisé une composé de formule générale I, en mélange avec le liant polymère.

4. Plaque d'impression selon l'une des revendications précédentes, caractérisé par le fait que la couche photopolymérisable formant relief est couverte d'une feuille protectrice détachable.

5. Plaque d'impression selon l'une des revendications précédentes, caractérisé par le fait que dans la formule (I), R¹ est mis pour hydrogène ou méthyle et X pour le reste

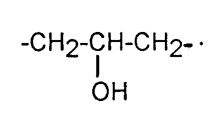

6. Plaque d'impresssion selon l'une des revendications précédentes, caractérisé par le fait que, comme copolymère soluble dans l'eau du polyalcoolvinylique, est introduit un copolymérisat greffé, au moins partiellement saponifié, d'un ester vinylique sur polyéthylénoxyde.

7. Plaque d'impression selon l'une des revendications 1 à 5, caractérisé par le fait que, comme dérivé soluble dans l'eau du polyalcoolvinylique, est introduit un polyalcoolvinylique partiellement estérifié avec l'acide méthacrylique et/ou un polyalcoolvinylique partiellement acétalisé.

8. Plaque d'impression selon l'une des revendications précédentes, caractérisé par le fait que la couche photopolymérisable formant relief contient un photoinitiateur qui, lors de l'exposition à la lumière actinique, déclenche une rapide photopolymérisation dans la couche, de même, de manière connue en soi, une combinaison d'un colorant avec un agent de réduction pour ce colorant, ne déclenchant dans la couche pas de photopolymérisation notable lors de l'exposition à la lumière actinique, l'agent de réduction ne reduisant pas le colorant en l'absence de lumière actinique, mais permettant toutefois la réduction lors de l'exposition à la lumière du colorant dans un état électronique excité.
